Europäisches Patentamt

(19) European Patent Office

Office européen des brevets

(11) Numéro de publication: **0 097 075**
**B1**

(12) **FASCICULE DE BREVET EUROPEEN**

(45) Date de publication du fascicule du brevet:
09.04.86

(21) Numéro de dépôt: **83401077.9**

(22) Date de dépôt: **27.05.83**

(51) Int. Cl.⁴: **H 03 D 9/06, H 01 P 5/10**

(54) Mélangeur d'ondes électromagnétiques hyperfréquences.

(30) Priorité: **08.06.82 FR 8209957**

(43) Date de publication de la demande:
**28.12.83 Bulletin 83/52**

(45) Mention de la délivrance du brevet:
**09.04.86 Bulletin 86/15**

(84) Etats contractants désignés:
**DE GB IT NL**

(56) Documents cités:
**EP - A - 0 022 990**
**DE - A - 3 018 307**
**US - A - 3 523 260**
**US - A - 3 939 430**

**PATENTS ABSTRACTS OF JAPAN, vol. 5, no.**
**133(E-71)(805), 25 août 1981, page 160E71**
**PATENTS ABSTRACTS OF JAPAN, vol. 6, no.**
**28(E-95)(906), 19 février 1982, page 150E95**
**PATENTS ABSTRACTS OF JAPAN, vol. 5, no.**
**159(E-77)(831), 14 octobre 1981, page 19E77**
**PATENTS ABSTRACTS OF JAPAN, vol. 2, no. 149, 13**
**décembre 1978, page 9432E77**

(73) Titulaire: **THOMSON-CSF, 173, Boulevard Haussmann,**
**F-75379 Paris Cedex 08 (FR)**

(72) Inventeur: **Lacour, Clément François, THOMSON-CSF**
**SCPI 173, bld Haussmann, F-75379 Paris Cedex 08 (FR)**
Inventeur: **Latouche, Yannick, THOMSON-CSF**
**SCPI 173, bld Haussmann, F-75379 Paris Cedex 08 (FR)**

(74) Mandataire: **Weinmiller, Jürgen et al, Zeppelinstrasse 63,**
**D-8000 München 80 (DE)**

## Description

L'invention concerne les mélangeurs d'ondes électromagnétiques hyperfréquences à diodes utilisables pour les fréquences comprises entre 2 à 18 GHz environ et plus particulierement les mélangeurs symétriques équilibrés à deux diodes.

Le mélange de deux signaux sinusoïdaux de fréquences différentes à l'aide d'une ou plusieurs diodes est bien connu.

Dans le type de mélangeur réalisé avec une seule diode, le signal appliqué entre les extrémités de la diode est la somme d'un signal S incident de pulsation $\omega_S$ et d'un signal de pulsation $\omega_L$ transmis par un oscillateur local. Le signal de sortie résultant est un signal dont le spectre est compose de plusieurs pulsations $\omega_{imn}$ = $\pm\, m\, \omega_s \pm n\, \omega_L$ où m et n sont des entiers dont chaque composante peut être isolée par un filtre pour être exploitée.

Les mélangeurs à plusieurs diodes sont généralement du type symétrique, c'est-à-dire qu'à tout instant une moitié des diodes seulement est conductrice. Les mélangeurs symétriques permettent, comme les mélangeurs à une diode, d'obtenir une fréquence intermédiaire dont la pulsation représente la différence des pulsations des composantes fondamentales du signal incident et du signal formé par l'oscillateur local. Ils presentent comme avantage, par rapport aux mélangeurs à une diode, de supprimer certains produits d'intermodulation où apparaissent les harmoniques paires du signal et d'autoriser la récupération de la fréquence image du signal incident à la condition toutefois qu'ils soient parfaitement équilibrés, c'est-à-dire que le signal d'acces ou le signal de l'oscillateur local puissent se répartir également ou symétriquement sur chacune des diodes.

Une façon de réaliser cet équilibre est obtenue, par exemple, dans un mélangeur symétrique à 2 diodes en plaçant les diodes du mélangeur aux bornes de l'enroulement secondaire d'un transformateur à point milieu. Le signal incident est appliqué aux bornes de l'enroulement primaire et le signal fourni par l'oscillateur local est appliqué entre le point de liaison commun aux 2 diodes et le point milieu du transformateur. Cette solution présente comme autre avantage de pouvoir réaliser éventuellement un isolement entre la ligne de masse transportant le signal incident et la ligne de masse transportant le signal de l'oscillateur local.

Malheureusement un tel dispositif n'est pas directement applicable à la réalisation des mélangeurs en hyperfréquence, par suite des difficultés qu'il y a à contruire des transformateurs bobinés utilisables dans ces gammes de fréquence. L'adaptation, selon par exemple le document US-A-3 939.430, de cette solution au domaine des hyperfréquences nécessite l'emploi d'un circuit hyperfréquence qui est équivalent sur le plan fonctionnel au transformateur à point milieu utilisé pour des domaines de fréquences plus basses. On connait effectivement des coupleurs hyperfréquences qui ont cette propriété et qui sont désignés dans la littérature anglo-saxonne sous le nom de "BALUN" qui est une abréviation du terme anglo-saxon "Balanced Unbalanced". Ces coupleurs sont réalisés soit à l'aide de lignes coaxiales, soit à l'aide de guides d'ondes constitués par des microrubans déposés par métallisation sur un substrat, encore appelés circuits "microstrips".

Dans le premier mode de réalisation le coupleur est constitué par une première ligne coaxiale de longueur égale au quart de longueur d'onde du signal incident, reliée par une extrémité aux entrées couplées en parallèle de deux autres lignes coaxiales. Selon cette configuration le signal incident est appliqué sur l'extrémité libre de la ligne coaxiale quart d'onde et les signaux sysmétriques sont prélevés aux sorties respectives des deux autres lignes coaxiales.

Suivant l'autre mode de réalisation, le coupleur est réalisé à l'aide de lignes à microrubans et il comporte une ligne bifilaire constituée par deux conducteurs parallèles placés respectivement sur une première face et sur une deuxième face d'un substrat, et une ou plusieurs diodes montées en série à une première extrémité de la ligne bifilaire et entre les deux conducteurs situés à cette extrémité, une entrée d'onde incidente étant connectée à la deuxième extrémité de la ligne bifilaire entre le conducteur situé à cette extrémité sur la deuxième face du substrat et une ligne de masse située sur la première face, une entrée d'onde mélangeuse étant connectée à des moyens pour appliquer entre les extrémités de chacune des diodes un champ électrique produit par ladite onde mélangeuse, et une sortie d'onde mélangée étant connectée entre au moins une extrémité d'unediode et la ligne de masse.

Pour des questions d'encombrements, le mode de réalisation à l'aide de guide d'onde à microrubans est souvent préféré au mode de réalisation à l'aide de lignes coaxiales car il permet d'obtenir des dimensions du boîtier de connexion beaucoup plus réduites. On cherche en effet, à obtenir une réduction maximum des dimensions du boîtier du mélangeur, pour éviter les phénomènes de résonance parasites qui peuvent se produire dès que l'on travaille dans une zone de fréquence approchant 10 GHz.

Or cette réduction n'apparaît plus possible, en dessous d'une certaine limite qui apparaît étroitement liée, comme expliqué precédemment, au quart de la longueur d'onde du signal définissant la longueur du coupleur et en dessous de laquelle les signaux prélevés en sortie du coupleur ne sont plus symétriques.

Un autre problème qui se pose et qui gêne considérablement la réduction des dimensions du mélangeur est dû au fait que les coupleurs type "BALUN" à microrubans ne permettent pas d'isoler les masses de l'oscillateur local et du signal incident, si bien qu'il existe des risques de mise en court-circuit des extrémités des diodes connectés à la sortie du coupleur ou de mise à la masse du signal incident par le circuit de masse appartenant à l'oscillateur local. Ces court-circuits peuvent être évités si une longueur suffisante de métallisation sépare les points de connexion des diodes des points de masse sur lesquels sont appliqués le signal incident et le signal de l'oscillateur local. Cette disposition va naturellement à l'encontre des réductions des dimensions du mélangeur souhaité, et augmente les risques de résonance parasites à l'intérieur du boîtier.

Le but de l'invention est de réaliser un mélangeur hyperfréquence à l'aide de lignes à microrubans et de lignes à fente dont les dimensions sont notablement réduites par rapport aux dimensions des mélangeurs actuellement connus sans que cette réduction se limite aux impossibilités et entraîne les inconvénients précités.

A cet effet, l'invention a pour objet, un mélangeur d'ondes électromagnétiques hyperfréquences réalisé à l'aide de lignes à microrubans et de lignes à fentes et comportant, une ligne bifilaire constituée par deux conducteurs parallèles placés respectivement sur une première face et sur une deuxième face d'un substrat, une ou plusieurs diodes montées en série à une première extrémité de la ligne bifilaire et entre les deux conducteurs situés à cette extrémité, une entrée d'onde incidente connectée à la deuxième extrémité de la ligne bifilaire entre le conducteur situé à cette extrémité sur la deuxième face du substrat et une ligne de masse située sur la première face, une entrée d'onde mélangeuse connectée à des moyens pour appliquer entre les extrémités de chacune des diodes un champ électrique produit par l'onde mélangeuse, et une sortie d'onde mélangée connectée entre au moins une extrémité d'une diode et la ligne de masse, caractérisé en ce que l'extrémité du conducteur située sur la première face à la deuxieme extrémité de la ligne bifilaire est laissée libre et est isolée électriquement de la ligne de masse par un espace d'une grandeur de quelques centaines de microns, et en ce que la longueur des conducteurs parallèles de la ligne bifilaire est inférieur au quart de la longueur d'onde de l'onde incidente.

D'autres caractéristiques et avantages de l'invention apparaîtront au cours de la description faite au regard des dessins annexés, donnés uniquement à titre d'exemple et dans lesquels:

La figure 1 représente le schéma de principe d'un mélangeur hyperfréquence symétrique à deux diodes réalisé conformément à l'invention.

La figure 2 représente un mode de réalisation selon l'invention du mélangeur de la figure 1 dans la technique des guides d'onde à microrubans.

La figure 3 représente une vue de dessus du mélangeur de la figure 2 dans son boîtier.

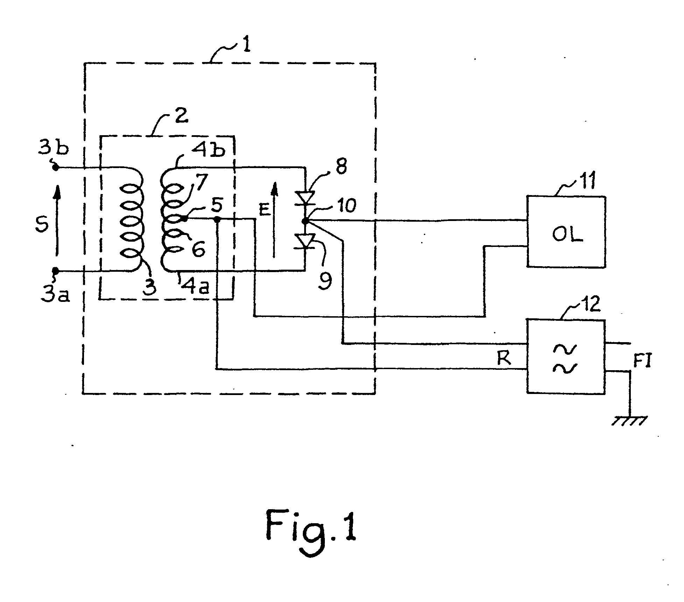

Le mélangeur représenté à l'intérieur du rectangle en pointillé 1, sur le schéma de principe de la figure 1 est constitué par un transformateur 2 comprenant un enroulement primaire 3, un enroulement secondaire 4 muni d'un point milieu 5, pour constituer deux demi enroulements 6 et 7.

Deux diodes 8 et 9 sont montées en série entre les extrémités 4a et 4b de l'enroulement secondaire 4, la cathode d'une diode étant reliée à l'anode de l'autre diode pour former un point de liaison commun 10. Le signal incident S à mélanger est appliqué par une source de signal extérieure, non représentée, entre les extrémités 3a et 3b de l'enroulement primaire 3 et le signal mélangeur OL est appliqué entre le point commun 10 aux deux diodes 8 et 9 et le point milieu 5 de l'enroulement secondaire 4 par un oscillateur local 11. Le signal mélangé R est obtenu entre le point commun 10 aux deux diodes et le point milieu 5 de l'enroulement secondaire 4 et est appliqué à l'entrée d'un filtre 12 pour recupérer une fréquence inter médiaire FI.

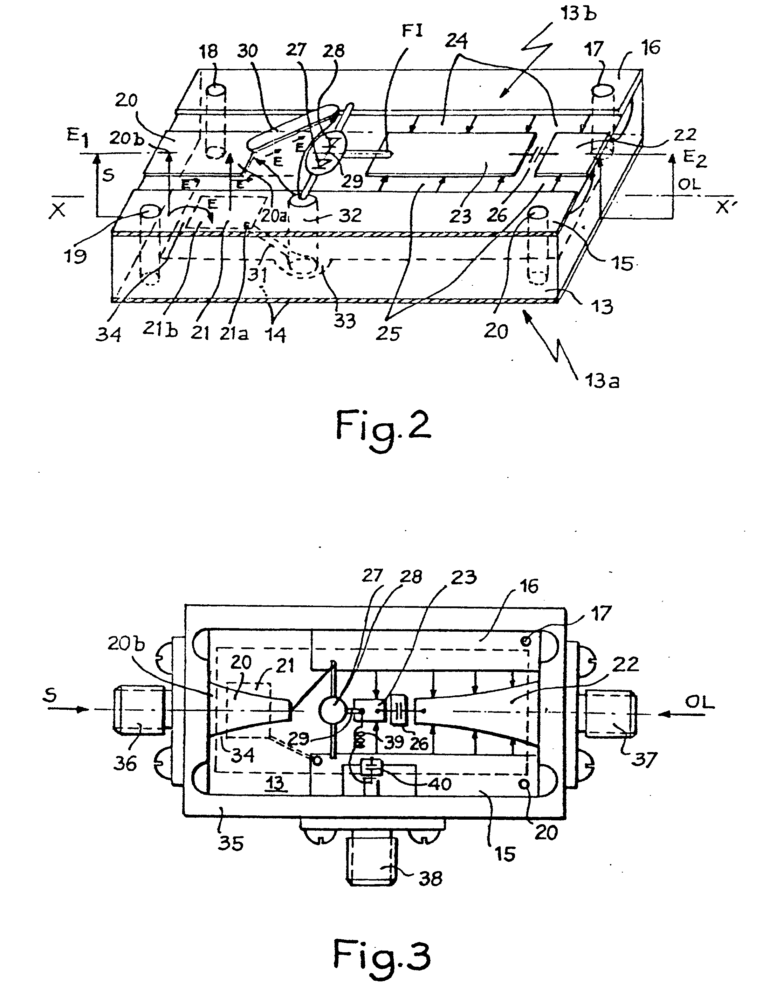

Un mode de réalisation, selon l'invention, du mélangeur de la figure 1 est représenté à la figure 2. Il comprend un substrat 13 composé par deux faces rectangulaires planes 13a et 13b parallèles entre elles et espacées de quelque 1/10 de mm, constitué par un matériau à permittivité élevée du type titanate de magnésium, alumine ou verre téflon. Une ligne de masse 14 est déposée par métallisation d'un ruban ou autres procédés analogues sur la périphérie de la première face 13a. Une deuxième ligne 15 et une troisième ligne 16, sont déposées par métallisation d'un ruban ou procédés analogues sur la deuxieme face 13b du substrat le long des grands côtés respectifs du rectangle délimitant la face 13b.

Les extrémités des lignes 15 et 16 sont reliées à la ligne de masse 14 située sur la face opposée par des trous métallisés 16, 17, 18, 19 traversant le substrat dans toute son épaisseur et disposés aux quatre coins de celui-ci. Un conducteur 20 est placé par métallisation d'un ruban ou tout autre moyen analogue sur la deuxième face 13b du substrat à une première extrémité $E_1$ de l'axe longitudinale XX' du substrat entre les lignes 15 et 16 suivant une direction parallèle à celles-ci. Un deuxième conducteur 21 parallèle et de longueur à peu près égale au conducteur 20 est placé par métallisation d'un ruban ou tout autre moyen analogue sur la première face 13a du substrat à l'aplomb du conducteur 20 à l'intérieur du contour formé par la ligne de masse 14. Deux autres lignes 22 et 23 sont également déposées bout à bout, par métallisation d'un ruban ou analogue sur la deuxième face 13b du substrat, entre les lignes 15 et 16 dans une direction parallèle à celles-ci pour former deux lignes à fente 24 et 25. La ligne 22 est placée à la deuxieme extrémité $E_2$ de l'axe longitudinal XX' dususubstrat et est séparée d'une première extrémité correspondante de la ligne 23 par un condensateur 26 connecté sur chacune des extrémités reliant les deux lignes 22 et 23 entre elles. Deux diodes 27 et 28 du type D5846A fabriquées par ALPHA sont montées en série, d'une part, entre les bords internes des lignes 15 et 16 et d'autre part entre le conducteur 20 et la ligne 23 dans une direction à peu près perpendiculaire à l'axe longitudinal du substratde façon que l'anode de la diode 28 soit reliée au bord interne de la ligne 16 et que la cathode de la diode 27 soit reliée au bord interne de la ligne 15. Le point commun 29 de liaison des deux diodes 27 et 28 est relie a la deuxième extrémité de la ligne 23. L'extrémité 20a du conducteur 20, directementen regard des diodes 27 et 28, est reliée par un fil conducteur 30 à un pointdu bord interne de la ligne 16, à proximité immédiate du point de connexionde la diode 28 sur le bord interne de la ligne 16. De façon à peu près similaire, l'extrémité 21a du conducteur 21, la plus proche des diodes 25 et 26 et située par rapport à elles de l'autre côté du substrat, est reliée à un point d'un bord interne de la ligne 15, par un fil conducteur 31 et par un trou métallisé 32 situé à proximité immédiate du point de connexion dela diode 27 traversant le substrat dans toute son épaisseur.

Pour éviter de créer un court-circuit vers la ligne de masse 14 du signal haute fréquence présent sur la ligne 15 au niveau du trou métallisé 32, une échancrure 33 peut être pratiquée au besoin dans la ligne de masse 14 pour isoler le trou métallisé 32 de la ligne de masse 14. L'extrémité 21b opposée à l'extrémité 21a du conducteur 21 est laissée libre et estisolée électriquement de la ligne de masse 14 à proximité de la première extremite $E_1$ de l'axe longitudinal du substrat, par un espace 34 de quelques centaines de microns qui évite de court-circuiter à la masse l'extrémité de la diode 27 reliée au trou métallisé 32 et qui permet de rallonger artificiellement la longueur électrique du conducteur 21, par une longueur qui correspond à la valeur de la capacité créée par la fente 34.

Cette disposition apparait primordiale pour atteindre le but fixé par l'invention car elle permet au coupleur formé par les conducteurs 20 et 21 d'avoir une longueur bien inférieure au 1/4 de longueur d'onde de l'onde incidente du signal S.

Le fonctionnement du mélangeur représenté à la figure 2 est le suivant.

Le champ électrique $\vec{E}$ du signal incident est appliqué entre l'extrémité 20b du conducteur 20 et la ligne de masse 14 située directement en regard. Le champ $\vec{E}$ se propage jusqu'aux extrémités 20a et 21a des conducteurs parallèles 20 et 21 par le guide d'onde formé par ces deux conducteurs et par l'intermédiaire de la fente constituée par l'espace 34 entre la ligne de masse 14 et l'extrémité 21b du conducteur 21.

Le champ $\vec{E}$ qui est présent aux extrémités 20a et 21a dérive d'un potentiel V non représenté qui représente la différence de potentiel développée aux bornes des extrémités 20a et 21a. Cette différence de potentiel V apparaît grâce au trou métallisé 32, aux bornes des diodes 27 et 28 au bord interne correspondant des lignes 15 et 16 et par suite le champ électrique $\vec{E}$ se retrouve aux niveaux des diodes dans la même direction que celles-ci. Comme les diodes ont des résistances à peu près égales, lechamp $\vec{E}$ incident se partage de façon égale dans celles-ci.

D'autre part le champ électrique, transmis par l'oscillateur local, est appliqué à l'extrémité $E_2$ du substrat, entre l'extrémité en regard de la ligne 22 et la ligne de masse 14. Du fait de la présence des trous métallisés 17 et 20 situés à l'extrémité $E_2$, le champ électrique créé par l'oscillateur local se propage dans la direction longitudinale des lignes à fente 24 et 25, jusqu'aux diodes, suivant des vecteurs champ d'orientation opposée. Un mélange est par consequent réalisé, tout a tour, dans chacune des diodes qui vues de l'oscillateur local, apparaissent montées tête bêche. Le produit du mélange est recueilli sur l'extrémité de la ligne 23 reliée au point milieu 29.

Le mélangeur qui vient d'être décrit est montré en vue de dessus dans un boîtier 35 de forme rectangulaire à la figure 3. Ce boîtier comprend trois prises coaxiales 36, 37 et 38. La prise 36 assure la liaison entre l'extrémité 20b du conducteur 20 et un câble coaxial extérieur,non représenté, qui transporte le signal incident. La prise 37 assure la liaison entre l'extrémité de ligne 22 située à l'extrémité $E_2$ du mélangeur et un câble coaxial extérieur non représenté qui transporte le signal fournipar un oscillateur local également non représenté. La prise 38 est reliée aupoint milieu 29 des diodes par l'intermédiaire d'un filtre passe-bas, constituépar une inductance 39 et un condensateur 40, pour transmettre à l'extérieur un signal de fréquence intermédiaire FI.

On remarque sur la figure 3, que contrairement a ce qui est represente a la figure 2, la longueur des lignes 15 et 16 ne correspond plus a la longueur de la dimension longitudinale du substrat et est arrêtée àla hauteur des points de fixation des diodes 27 et 28. Cette réalisation permet de constater que le champ incident se propage effectivement entre les conducteurs 20 et 21 et non pas dans les deux lignes à fente formées par le conducteur 20 et les lignes 15 et 16 comme on aurait pu le penser étant donné la configuration des plans de masse. En fait toujours sur la figure 2 la ligne à fente placée entre le conducteur 20 et la ligne de masse 16 est court-circuitée par le fil 30 et de l'autre côté on a constaté par expérience, qu'aucun champ n'existait entre le conducteur 20 et la ligne de masse 15.

On remarque également sur la figure 3 que le rapport des longueurs des lignes 22 et 23 est inversé par rapport à celui de la figure 2.

Ce rapport n'est en effet pas critique, il est en fait déterminé par la présence du condensateur 26 qui doit être placé de préférence leplus près possible du point milieu 29 pour réaliser au mieux sa fonction de blocage de la fréquence intermédiaire fourni par le résultat du mélange.

Le mélangeur qui vient d'être décrit a été réalisé dans un boîtier de 18 x 15 millimètres et, présente des pertes de conversion relativement faible de l'ordre de 6 décibels pour des fréquences voisines de 2 GHz.

La miniaturisation obtenue représente un progrès considérable par rapport aux mélangeurs symétriques utilisant le système BALUN puisqu'à 2 GHz les mélangeurs connus ont des dimensions minimum en longueur de l'ordre de 40 millimètres.

L'invention n'est pas limitée au mélangeur précédemment décrit, il va de soi qu'elle s'applique également à tout type de mélangeur comportant une ou plusieurs diodes dans lequel on veut réduire la longueur des conducteurs servant de guide d'onde pour le signal incident. Dans le cas d'un mélangeur à une ou plusieurs diodes l'ensemble des conducteurs d'accès 20, 21 et d'espace 34 pourront être conservés, seules devront être adaptées les lignes à fente chargées d'appliquer le champ de l'oscillateur local au borne de chacune des diodes.

**Revendications**

1/ Mélangeur d'ondes électromagnétiques hyperfréquences réalisé à l'aide de lignes à microrubans et de lignes à fentes et comportant, une ligne bifilaire constituée par deux conducteurs (20, 21) parallèles placés respectivement sur une première face (13a) et sur une deuxième face (13b) d'un substrat (13), une ou plusieurs diodes (27, 28) montées en série à une première extrèmité (20a, 21a) de la ligne bifilaire et entre les deux conducteurs (20, 21) situés à cette extrémité, une entrée d'onde incidente (S) connectée à la deuxième extrémité de la ligne bifilaire entre le conducteur (20) situé à cette extrémité (20b) sur la deuxième face (13b) du substrat (13) et une ligne de masse (14) située sur la première face, une entrée d'onde mélangeuse (OL) connectée à des moyens (24, 15) pour appliquer entre les extrémités de chacune des diodes (27, 28) un champ électrique produit par l'onde mélangeuse, et une sortie d'onde mélangée (FI) connectée entre au moins une extrémité (29) d'une diode et la ligne de masse (14), caractérisé en ce que l'extrémité (21b) du conducteur (21) située sur la première face (13a) à la deuxième extrémité de la ligne bifilaire est laissée libre et est isolée électriquement de la ligne de masse par un espace (34) d'une grandeur de quelques centaines de microns, et en ce que la longueur des conducteurs parallèles de la ligne bifilaire est inférieure au 1/4 de longueur d'onde (20, 21) de l'onde (S) incidente.

2/ Mélangeur selon la revendication 1, caractérisé en ce que les moyens pour appliquer entre les extrémités de chacune des diodes un champ électrique produit par l'onde mélangeuse sont constitués chacun par une ligne à fente (24, 25).

3/ Mélangeur selon la revendication 2, caractérisé en ce que chaque ligne à fente (24, 25) est constituée par deux lignes parallèles espacées (23, 16; 23, 15), déposées par métallisation d'un ruban surla face (13b) du substrat qui ne supporte pas la ligne de masse (14), une ligne parallèle (15, 16) étant reliée électriquement à la ligne de masse par au moins un trou métallisé (17, 18, 19, 20) traversant l'épaisseur du substrat.

4/ Mélangeur selon les revendications 2 ou 3, caractérisé en ce que les extrémités de chaque diode (27, 28) sont connectées entre les bords intérieurs de l'extrémité d'une ligne à fente (24, 25), l'autre extrémité de la ligne à fente étant connectée à l'entrée de l'onde mélangeuse (OL).

5/ Mélangeur selon l'une quelconque des revendications 1 à 4, caractérisé en ce que les diodes (27, 28) sont disposées sur la deuxieme face (13b) du substrat et que leur liaison avec le conducteur (21) situé sur la première face est effectuée par l'intermédiaire d'un trou métallisé (32) traversant l'épaisseur du substrat.

6/ Mélangeur selon l'une quelconque des revendications précédentes, caractérisé en ce qu'il comprend deux diodes (27, 28), le point commun (29) aux deux diodes étant relié à l'extrémité d'une première ligne (23) commune à deux lignes à fente (24, 25) constituées par la première ligne (23) et deux autres lignes (15, 16) situées à proximité et de part et d'autre de la première ligne sur la deuxième face (13b) du substrat et reliées à la ligne de masse située sur la première face par des trous métallisés (17, 18, 19, 20).

7/ Mélangeur selon la revendication 6, caractérisé en ce que la première ligne est partagée en deux éléments de ligne (22, 23) reliés entre eux par un condensateur (26).

8/ Mélangeur selon les revendications 6 ou 7, caractérisé en ce que le point commun (29) aux deux diodes est relié à la sortie d'onde mélangée par un filtre passe-bas (39, 40).

**Claims**

1. A mixer for electromagnetic microwaves realized by means of microstrip lines and slot lines, and comprising a two-wire line constituted by two parallel conductors (20, 21) placed parallelly on a first face (13a) and on a second face (13b) respectively of a substrate (13), one or several diodes (27, 28) mounted in series at a first end (20a, 21a) of the two-wire line and between the two conductors (20, 21) located at said end, an incident-wave input (S) connected to the second end of the two-wire line between the conductor (20) located at said end (20b) on the second face (13b) of the substrate (13) and a ground line (14) located on the first face, a mixing-wave input (OL) connected to means (24, 15) for applying between the ends of each diode (27, 28) an electric field produced by the mixing wave, and a mixed-wave output (Fi) connected between at least one end (29) of a diode and the ground line (14), characterized in that that end (21b) of the conductor (21) which is located on the first face (13a) at the second end of the two-wire line is left free and is electrically insulated from said ground line by means of a gap (34) having a width of a few hundred microns, and that the length of the parallel conductors of the two-wire line is shorter than one-quarter wavelength (20, 21) of the incident wave (S).

2. A mixer according to claim 1, characterized in that the means for applying between the ends of each diode an electric field produced by the mixing wave are each constituted by a slot line (24, 25).

3. A mixer according to claim 2, characterized in that each slot line (24, 25) is constituted by two spaced parallel lines (23, 16; 23, 15) deposited by metallization of a strip on that face (13b) of the substrate which does not carry the ground line (14), a parallel line (15, 16) being electrically connected to the ground line by means of at least one metallized hole (17, 18, 19, 20) extending right through the substrate from one side to the other.

4. A mixer according to claim 2 or 3, characterized in that the ends of each diode (27, 28) are connected between the inner edges of the end of a slot line (24, 25), the other end of said slot line being connected to the mixing-wave input (OL).

5. A mixer according to any one of claims 1 to 4, characterized in that the diodes (27, 28) are placed on the second face (13b) of the substrate and are connected to the conductor (21) located on the first face by means of a metallized hole (32) extending right through the substrate from one side to the other.

6. A mixer according to any one of the preceding claims, characterized in that it comprises two diodes (27, 28), the common point (29) of the two diodes being connected to the end of a first line (23) which is common to two slot lines (24, 25) constituted by the first line (23) and two other lines (15, 16) located in proximity to and on each side of the first line on the second face (13b) of the substrate and connected by means of metallized holes (17, 18, 19, 20) to the ground line located on the first face.

7. A mixer according to claim 6, characterized in that the first line is divided into two line elements which are interconnected by a capacitor (26).

8. A mixer according to claim 6 or 7, characterized in that the point (29) which is common to the two diodes is connected to the mixed-wave input by means of a low-pass filter (39, 40).

## Patentansprüche

1. Mischer für elektromagnetische Mikrowellen, der mithilfe von Mikrostripleitungen und Schlitzleitungen hergestellt ist und eine von zwei parallelen Leitern (20, 21), die auf den beiden Seiten (13a, 13b) eines Substrats (13) liegen, bestehende Zweidrahtleitung, eine oder mehrere in Reihe geschaltete Dioden (27, 28), die an einem ersten Ende (20a, 21a) der Zweidrahtleitung und zwischen den beiden Leitern (20, 21) an diesem Ende liegen, einen Eingang für die einfallende Welle (S), der an das zweite Ende der Zweidrahtleitung zwischen dem Leiter (20), der an diesem Ende (20b) an der zweiten Seite (13b) des Substrats (13) liegt, und eine Masseleitung (14), die auf der ersten Seite liegt, eingefügt ist, einen Mischwelleneingang (OL), der an Mittel (24, 15) zum Anlegen eines von der Mischwelle erzeugten elektrischen Feldes zwischen die Enden jeder der Dioden (27, 28) angeschlossen ist, und einen Ausgang (FI) für die gemischte Welle aufweist, der zwischen mindestens ein Ende (29) einer Diode und der Masseleitung (14) liegt, dadurch gekennzeichnet, daß das Ende (21b) des auf der ersten Seite (13a) am zweiten Ende der Zweidrahtleitung liegenden Leiters (21) freigelassen bleibt und elektrisch gegen die Masseleitung durch einen Abstand (34) einer Größenordnung von einigen hundert Mikron isoliert ist, und daß die Länge der parallelen Leiter der Zweidrahtleitung geringer als ein Viertel der Wellenlänge (20, 21) der einfallenden Welle (S) ist.

2. Mischer nach Anspruch 1, dadurch gekennzeichnet daß die Mittel zum Anlegen eines durch die Mischwelle erzeugten elektrischen Feldes zwischen die Enden jeder der Dioden je aus einer Schlitzleitung (24, 25) bestehen.

3. Mischer nach Anspruch 2, dadurch gekennzeichnet, daß jede Schlitzleitung (24, 25) aus zwei im Abstand zueinander parallel verlaufenden Leitungen (23, 16; 23, 15) gebildet wird, die durch Metallisierung eines Strips auf derjenigen Seite (13b) des Substrats gebildet wird, die nicht die Masseleitung (14) trägt, wobei eine parallele Leitung (15, 16) elektrisch an die Masseleitung über mindestens ein metallisiertes Loch (17, 18, 19, 20) angeschlossen ist, das die Dicke des Substrats durchquert.

4. Mischer nach den Ansprüchen 2 oder 3, dadurch gekennzeichnet, daß die Enden jeder Diode (27, 28) zwischen die Innenränder der Enden einer Schlitzleitung (24, 25) angeschlossen sind, wobei das andere Ende der Schlitzleitung mit dem Mischwelleneingang (OL) verbunden ist.

5. Mischer nach einem beliebigen der Ansprüche 1 bis 4, dadurch gekennzeichnet, daß die Dioden (27, 28) auf der zweiten Seite (13b) des Substrats liegen und daß ihre Verbindung mit dem Leiter (21), der auf der ersten Seite sitzt, durch ein metallisiertes Loch (32) hindurch erfolgt, das die Dicke des Substrats durchquert.

6. Mischer nach einem beliebigen der vorhergehenden Ansprüche, dadurch gekennzeichnet, daß er zwei Dioden (27, 28) aufweist, deren gemeinsamer Punkt (29) an das Ende einer ersten Leitung (23) angelegt ist, die eine gemeinsame Leitung für zwei Schlitzleitungen (24) bildet, welche von der ersten Leitung (23) und zwei weiteren Leitungen (15, 16) gebildet werden, die in der Nähe und zu beiden Seiten der ersten Leitung auf der zweiten Seite (13b) des Substrats liegen und an die auf der ersten Seite liegende Masseleitung über metallisierte Löcher (17, 18, 19, 20) angeschlossen sind.

7. Mischer nach Anspruch 6, dadurch gekennzeichne‚t daß die erste Leitung auf zwei Leitungselemente (22, 23) aufgeteilt ist, die miteinander über einen Kondensator (26) verbunden sind.

8. Mischer nach den Ansprüchen 6 oder 7, dadurch gekennzeichnet, daß der gemeinsame Punkt (29) der beiden Dioden an den Ausgang für die gemischte Welle über ein Tiefpaßfil-ter (39, 40) angeschlossen ist.

Fig.1

Fig.2

Fig.3